# EUROPEAN PATENT APPLICATION

(11) **EP 2 373 137 A1**
(43) Date of publication of application: **05.10.2011**
(21) Application number: 11159743.1
(22) Date of filing: 25.03.2011
(51) Int. Cl.: H05K 3/30, H01L 21/56, H01L 23/00

(54) **Printed circuit board unit, electronic device and method of fabricating printed circuit board**

(30) Priority: 30.03.2010 JP 2010078070
(71) Applicant: FUJITSU LIMITED, Kawasaki-shi, Kanagawa 211-8588 (JP)
(72) Inventor: Nakamura, Naoki, Kawasaki-shi Kanagawa 211-8588 (JP); Taketomi, Nobuo, Kawasaki-shi Kanagawa 211-8588 (JP); Hatanaka, Kiyoyuki, Kawasaki-shi Kanagawa 211-8588 (JP); Iriguchi, Shigeo, Kawasaki-shi Kanagawa 211-8588 (JP)
(74) Representative: Stebbing, Timothy Charles

(57) **Abstract**

A printed circuit board unit includes a printed circuit board and an electronic component. The electronic component is electrically connected to a predetermined position on the printed circuit board by means of soldering while being joined to the printed circuit board using an adhesive layer. The adhesive layer, disposed between the printed circuit board and the electronic component, partially includes a multilayer laminated region including a first reinforcement resin layer and a second reinforcement resin layer. The first reinforcement resin layer is disposed on a side of the printed circuit board, whereas the second reinforcement resin layer is disposed on a side of the electronic component. The second reinforcement resin layer has adhesive strength greater than that of the first reinforcement resin layer.

## Description

### FIELD

The present invention relates to a printed circuit board unit that an electronic component is mounted on a printed circuit board, an electronic device having the printed circuit board embedded therein and a method of fabricating a printed circuit board unit that an electronic component is mounted on a printed circuit board.

### BACKGROUND

In the recent portable electronic devices (the mobile phones, the laptop personal computers and etc.), a reinforcement resin called "underfill" is applied to clearances between electronic components and a printed circuit board for reinforcing joints between the electronic components and the printed circuit board. Reinforcement is herein executed for preventing the joint portions of the electronic components from being destroyed by large impact, for instance, applied when the portable electronic devices fall down. A thermosetting resin (e.g., an epoxy resin with high adhesive strength) is used as the above reinforcement resin.

On the other hand, a resin formed by blending a thermosetting adhesive material and a thermoplastic adhesive material may be used as the reinforcement resin to be used as the underfill for repairing the electronic components when there is something wrong with either the electronic components themselves or the joints of the electronic components to the printed circuit board. However, no reinforcement resin has been developed for reliably connecting the electronic components to the printed circuit board as the reinforcement resin and for easily repairing the electronic components.

Under the circumstances, Japan Laid-open Patent Application Publication No. JP-A-2008-277823 discusses a flip chip package including a board, a flip chip, a first underfill and a second underfill. The flip chip is mounted on the board. The first underfill is disposed on a chip connected portion on the substrate. The chip connected portion is herein a portion where the flip chip is electrically connected to the board. The second underfill is disposed on the other portions on the board excluding the chip connected portion. Further, the first underfill is made of a material having a strength greater than that of the second underfill.

In the aforementioned joint method, the flip chip can be mounted on the board by dividing the flip chip joint portions into the chip connected portions and the remaining portion excluding the chip connected portions. However, the aforementioned joint method using a resin may not be allowed to be used for the semiconductor packages such as the BGAs (Ball Grid Arrays) due to solder bumps uniformly distributed on the joint surface thereof.

### SUMMARY

To solve the aforementioned problem, it is an object in an aspect of the present invention to provide a printed circuit board unit, an electronic device and a method of fabricating a printed circuit board unit for sufficiently reinforcing joint of electronic components onto a printed circuit board when the electronic components are mounted to the printed circuit board while being allowed to be repaired.

According to an aspect of the present invention, a printed circuit board unit that an electronic component is mounted on a printed circuit board includes the printed circuit board and the electronic component. The electronic component is electrically connected to a predetermined position on the printed circuit board by means of soldering. The electronic component is joined to the printed circuit board using an adhesive layer. Further, the adhesive layer, disposed between the printed circuit board and the electronic component, partially includes a multilayer laminated region including a first reinforcement resin layer and a second reinforcement resin layer. The first reinforcement resin layer is disposed on a side of the printed circuit board, whereas the second reinforcement resin layer is disposed on a side of the electronic component. The second reinforcement resin layer has adhesive strength greater than that of the first reinforcement resin layer.

According to another aspect of the present invention, a printed circuit board unit that an electronic component is mounted on a printed circuit board includes the printed circuit board and the electronic component. The electronic component is electrically connected to a predetermined position on the printed circuit board by means of soldering. The electronic component is joined to the printed circuit board by means of an adhesive material. Further, the adhesive layer, disposed between the printed circuit board and the electronic component, partially includes a plurality of multilayer laminated regions. The multilayer laminated regions respectively include a first reinforcement resin layer and a second reinforcement resin layer. The first reinforcement resin layer is disposed on a side of the printed circuit board, whereas the second reinforcement resin layer is disposed on a side of the electronic component. The second reinforcement resin layer has adhesive strength greater than that of the first reinforcement resin layer. The electronic component is a semiconductor package embedded with a semiconductor chip. One of the multilayer laminated regions is disposed in an inner portion of a corresponding region indicative of a region corresponding to a mounting region of the semiconductor chip and away from an edge portion of the corresponding region on the adhesive layer. At least one of the multilayer laminated regions is disposed on the outside of the corresponding region and away from the edge portion of the corresponding region.

According to yet another aspect of the present invention, a method of fabricating a printed circuit board unit that an electronic component is mounted on a printed circuit board includes: forming a first reinforcement resin layer, which is either cured or half-cured and contains thermoplastic adhesive material, on the printed circuit board; applying a solder paste on a mounting pad of the printed circuit board that the first reinforcement resin layer is formed; joining the mounting pad of the printed circuit board on which the solder paste is formed and a solder bump of the electronic component to be mounted on the printed circuit board; and forming a second reinforcement resin layer by filling and curing a second adhesive material, which has an adhesive strength greater than an adhesive strength of the thermoplastic adhesive material, in a clearance between the electronic component and the printed circuit board and a clearance between the first reinforcement resin layer and the electronic component for reinforcing joint of the electronic component to the printed circuit board.

### BRIEF DESCRIPTION OF DRAWINGS

Referring now to the attached drawings which form a part of this original disclosure:
FIG. 1 is a diagram illustrating an exemplary portable electronic device including a printed circuit board unit of exemplary embodiments of the present invention;
FIG. 2A is a diagram illustrating a printed circuit board used in a first exemplary embodiment;
FIG. 2B is a diagram illustrating a mount of the semiconductor package of the first exemplary embodiment on the printed circuit board;
FIG. 3 is a diagram illustrating the semiconductor package of the first exemplary embodiment being removed from the printed circuit board;
FIG. 4A is a diagram illustrating a printed circuit board used in a second exemplary embodiment;
FIG. 4B is a diagram illustrating a mount of the semiconductor package of the second exemplary embodiment on the printed circuit board;
FIG. 5A is a diagram illustrating a printed circuit board used in a third exemplary embodiment;
FIG. 5B is a diagram illustrating a mount of the semiconductor package of the third exemplary embodiment on the printed circuit board;
FIG. 6A is a diagram illustrating a printed circuit board used in a fourth exemplary embodiment;
FIG. 6B is a diagram illustrating a mount of the semiconductor package of the fourth exemplary embodiment on the printed circuit board;
FIG. 7 is a flowchart representing an exemplary flow of a method of fabricating the printed circuit board unit of the present invention;
FIG. 8A is a diagram illustrating a conventional mount of a semiconductor package on a printed circuit board; and
FIG. 8B is a diagram illustrating a conventional mount of the semiconductor package on the printed circuit board.

### DESCRIPTION OF EMBODIMENT(S)

A printed circuit board unit, an electronic device and a method of fabricating a printed circuit board unit according to the present invention will be hereinafter explained.

### (Printed Circuit Board Unit)

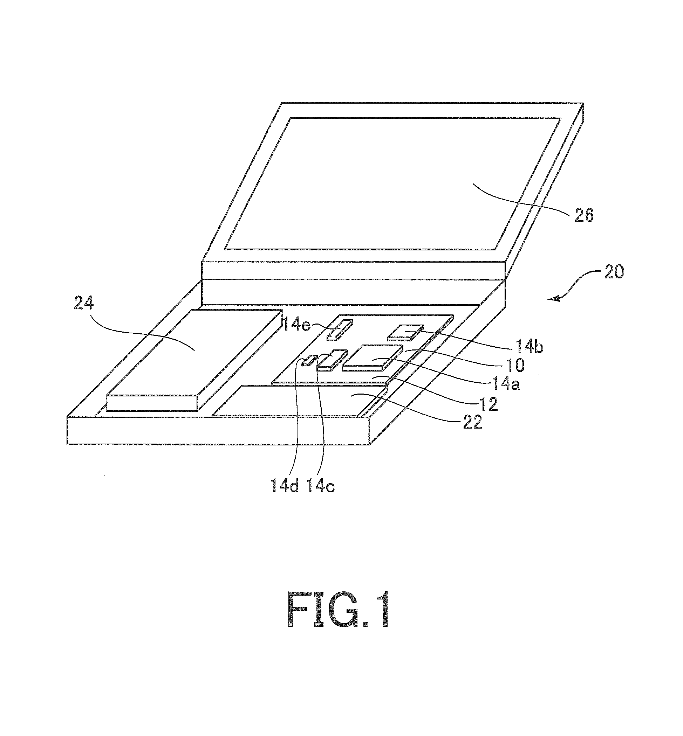

FIG. 1 schematically illustrates an inner configuration of a portable electronic device 20 of a first exemplary embodiment having a printed circuit board unit 10 embedded therein. Input operation units such as a keyboard and a mouse/touchpad are detached from the portable electronic device 20 illustrated in FIG. 1. The portable electronic device 20 includes units 22 and 24 (a battery unit, a wireless transceiver unit, and etc.) and a display 26 in addition to the printed circuit board unit 10 including a CPU and the like. The printed circuit board unit 10 is a board that electronic components such as semiconductor packages are mounted.

In the printed circuit board unit 10, a plurality of electronic components (i.e., semiconductor packages 14a, 14b, 14c, 14d and 14e) are mounted on a surface of a printed circuit board 12. The semiconductor package 14a, one of the semiconductor packages 14a, 14b, 14c, 14d and 14e, includes a plurality of solder bumps on its surface faced to the printed circuit board 12. The solder bumps are made of solder balls and arranged at predetermined intervals. Each solder bump is soldered and electrically connected to a mounting pad of the printed circuit board 12 as a connection terminal of the semiconductor package 14a. For example, the semiconductor package 14a employs a BGA (Ball Grid Array). The semiconductor package 14a may employ a LGA (Land Grid Array), a CSP (Chip Size Package) or the like. Therefore, the solder bumps of the semiconductor package 14a are positioned between the body of the semiconductor package 14a and the printed circuit board 12. Bumps of the semiconductor packages 14b to 14e (not illustrated in the figures) are also connected to the mounting pads and the like disposed on the printed circuit board 12.

As described below, a resin for reinforcing soldering is applied between the aforementioned semiconductor package 14 and the printed circuit board 12. The soldering-reinforcement resin is applied for reinforcing soldering of the semiconductor package 14a to an extent that soldering of the semiconductor package 14a can be sufficiently maintained even if large stress or impact is applied to the semiconductor package 14a.

### (First Exemplary Embodiment Semiconductor Package)

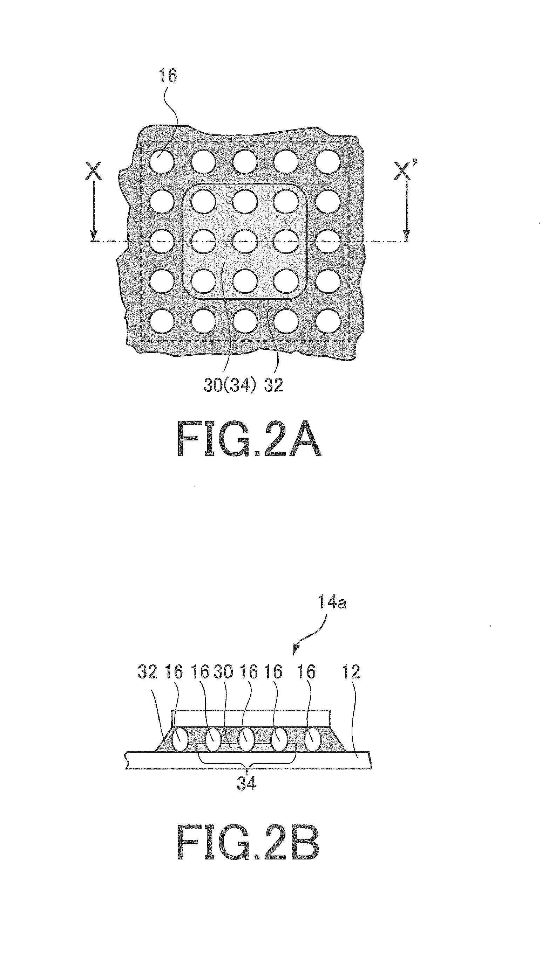

FIGS. 2A and 2B are diagrams illustrating a mount of the semiconductor package 14a having a rectangular mounting surface (i.e., a semiconductor package of the first exemplary embodiment) on the printed circuit board 12. FIG. 2A illustrates a mounting position of the body of the semiconductor package 14a mounted on the printed circuit board 12 (i.e., a position enclosed with a dotted line) and arrangement of an adhesive layer.

As illustrated in FIG. 2A, a plurality of solder bumps 16 are disposed at predetermined intervals on a surface, faced to the printed circuit board 12, of the semiconductor package 14a (The surface is hereinafter referred to as "a back surface").

FIG. 2B is a cross-sectional view of the semiconductor package 14a mounted on the printed circuit board 12 illustrated in FIG. 2A, which is sectioned along a line X-X'.

The semiconductor package 14a is soldered and electrically connected to a predetermined position on the printed circuit board 12. Simultaneously, the semiconductor package 14a is bonded to the printed circuit board 12 using a first reinforcement resin layer 30 and a second reinforcement resin layer 32. The adhesive layer, disposed between the printed circuit board 12 and the semiconductor package 14a, partially includes a multilayer laminated region 34. The multilayer laminated region 34 includes the first reinforcement resin layer 30 and the second reinforcement resin layer 32. The first reinforcement resin layer 30 is disposed on a side of the printed circuit board 12, thus closer to the printed circuit board 12 than the second reinforcement resin layer 32 is, whereas the second reinforcement resin layer 32, having an adhesive strength greater than that of the first reinforcement resin layer 30, is disposed on a side of the semiconductor package 14a, thus closer to the semiconductor package 14a than the first reinforcement resin layer 30 is. In the adhesive layer disposed between the printed circuit board 12 and the semiconductor package 14a, a layer disposed on a side of the printed circuit board 12 will be hereinafter referred to as "a lower layer", whereas a layer disposed on a side of the semiconductor package 14a will be hereinafter referred to as "an upper layer". The multilayer laminated region 34 is disposed within a region indicative of a mounting position of the semiconductor package 14a (i.e., a region enclosed by a dotted line in FIG. 2A), more specifically, on an inner portion of the region and away from an edge portion of the region. The term "adhesive strength" herein refers to, for instance, peel strength defined by JIS (Japan Industrial Standards) K6833.

The second reinforcement resin layer 32 is extended and disposed to surround the first reinforcement resin layer 30 of the multilayer laminated region 34 in a peripheral region of the multilayer laminated region 34.

The first reinforcement resin layer 30 is herein preferably an adhesive layer containing a thermoplastic rein, whereas the second reinforcement resin layer 32 is preferably an adhesive layer containing a thermosetting resin. The adhesive layer containing a thermoplastic resin may be herein a type of resin that a thermosetting resin is blended in a thermoplastic resin, as well as a type of resin made of a thermoplastic resin. Any suitable resins may be herein blended as long as the blended resins at least have thermoplastic properties. The adhesive layer containing a thermosetting resin may be herein a type of resin that a thermoplastic resin is blended in a thermosetting resin, as well as a type of resin made of a thermosetting resin. Any suitable resins may be herein blended as long as the blended resins at least have thermosetting properties. An acrylic series resin, a polyester series resin or a vinyl chloride series resin is used as a thermoplastic resin, for instance. On the other hand, an epoxy resin or a phenol resin is used as a thermosetting resin, for instance.

As described above, the multilayer laminated region 34, including the first reinforcement resin layer 30 as a lower layer and the second reinforcement resin layer 32 as an upper layer, is disposed on the inner portion of the region indicative of the mounting position of the semiconductor package 14a. With the structure, the entire back surface of the semiconductor package 14a is joined to the printed circuit board 12 through the second reinforcement resin layer 32 having a high adhesive strength. Therefore, the joint between the semiconductor package 14a and the printed circuit board 12 is sufficiently reinforced in the printed circuit board unit 10.

Further, the joint reinforcement is more reliably achieved due to the structure that the second reinforcement resin layer 32 is disposed to surround the first reinforcement resin layer 30 of the multilayer laminated region 34 in the peripheral region of the multilayer laminated region 34 of the semiconductor package 14a.

In contrast, the joint between a semiconductor package and a printed circuit board is not sufficiently reinforced if a conventional joint method is applied to the joint between the semiconductor package and the printed circuit board.

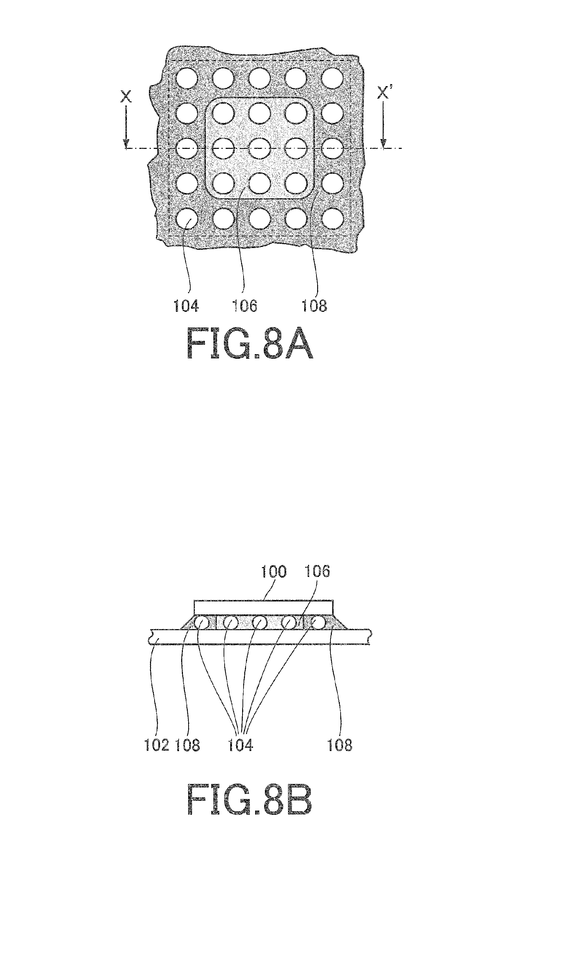

FIGS. 8A and 8B illustrate an exemplary case that a conventional joint method is applied to the joint between a semiconductor package 100 and a printed circuit board 102.

In the conventional joint method, for instance, a thermosetting resin is used as a a first underfill whereas a thermoplastic resin is used as a second underfill. In this case, a thermoplastic resin of a pre-cured state and a solder paste are appropriately applied to predetermined regions on the printed circuit board 102. As illustrated in FIGS. 8A and 8B, a plurality of solder bumps 104, disposed on a semiconductor-package-100 surface faced to the printed circuit board 102, is partially disposed within a region of an adhesive layer 106 made of a thermoplastic resin. An adhesive layer 108 made of a thermosetting resin is disposed to surround the adhesive layer 106. In this case, the adhesive layer 108 corresponds to the first underfill, whereas the adhesive layer 106 corresponds to the second underfill.

However, it is difficult to appropriately apply the thermoplastic resin and the solder paste to predetermined regions because each of the thermoplastic resin and the solder paste is in a paste state before the semiconductor package 100 is joined to the printed circuit board 102. On the other hand, the solder paste can be printed on a predetermined region after the thermoplastic resin is cured. However, the bonding between the electronic components and the thermoplastic resin is not sufficiently reinforced because adhesive strength of the bonding is reduced when the cured thermoplastic resin is reheated.

Further, a large part of the back surface of the semiconductor package 100 is joined to the printed circuit board 102 through the adhesive layer 106 having an adhesive strength less than that of the adhesive layer 108. Therefore, the joint between the semiconductor package 100 and the printed circuit board 102 is not sufficiently reinforced using the conventional joint method.

As described above, the joint between a semiconductor package and a printed circuit board is not sufficiently reinforced with the application of the conventional method. According to the first exemplary embodiment, in contrast, the joint between a semiconductor package and a printed circuit board is sufficiently reinforced by forming the multilayer laminated region 34 in the adhesive layer.

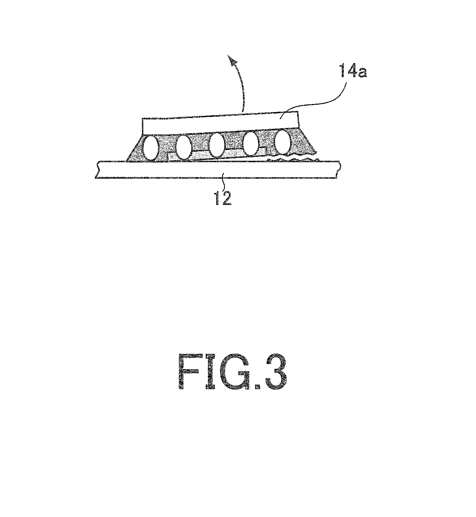

Further, in the first exemplary embodiment, the first reinforcement resin layer 30 is an adhesive layer containing a thermoplastic resin, whereas the second reinforcement resin layer 32 is an adhesive layer containing a thermosetting resin. Therefore, the adhesive strength of the first reinforcement resin layer 30 is reduced by heating to be executed in a repair process. Therefore, only the second reinforcement resin layer 32 substantially has an adhesion function. The adhesion area of the second reinforcement resin layer 32 is smaller than the total adhesion area of the first reinforcement resin layer 30 and the second reinforcement resin layer 32. Therefore, the adhesive strength of the entire adhesive layer is reduced. The semiconductor package 14a can be thereby easily removed from the printed circuit board 12 by physically breaking the second reinforcement resin layer 32 and simultaneously peeling the semiconductor package 14a from the printed circuit board 12, as illustrated in FIG. 3.

Further, the first reinforcement resin layer 30 containing a thermoplastic resin is allowed to be disposed on the printed circuit board 12 in a cured or half-cured state when the semiconductor package 14a is attached to the printed circuit board 12, as described below. Therefore, it is easy to apply a solder paste to a joint pad.

### (Second Exemplary Embodiment Semiconductor Package)

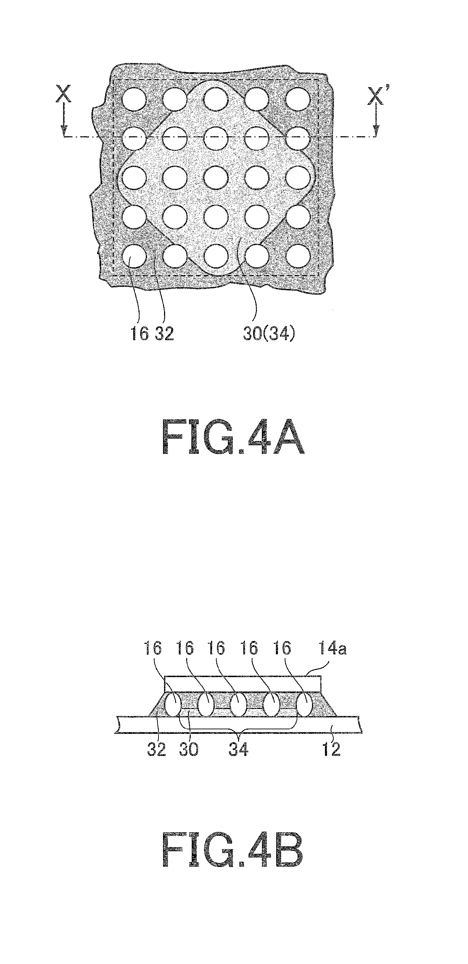

FIGS. 4A and 4B are diagrams illustrating a mount of the semiconductor package 14a of a second exemplary embodiment on the printed circuit board 12. The semiconductor package 14a of the second exemplary embodiment includes a rectangular mounting surface. Similarly to the first exemplary embodiment, the semiconductor package 14a also includes a plurality of the solder bumps 16 disposed at predetermined intervals on the back surface thereof.

FIG. 4B is a cross-sectional view of the semiconductor package 14a mounted on the printed circuit board 12 illustrated in FIG. 4A, which is sectioned along a line X-X'.

The semiconductor package 14a is soldered and electrically connected to a predetermined position on the printed circuit board 12. Simultaneously, the semiconductor package 14a is joined to the printed circuit board 12 using the first reinforcement resin layer 30 and the second reinforcement resin layer 32. The adhesive layer, disposed between the printed circuit board 12 and the semiconductor package 14a, partially includes the multilayer laminated region 34. The multilayer laminated region 34 includes the first reinforcement resin layer 30 as a lower layer and the second reinforcement resin layer 32 as an upper layer. The second reinforcement resin layer 32 has an adhesive strength greater than that of the first reinforcement resin layer 30. The first reinforcement resin layer 30 is herein preferably an adhesive layer containing a thermoplastic rein, whereas the second reinforcement resin layer 32 is preferably an adhesive layer containing a thermosetting resin.

The semiconductor package 14a of the second exemplary embodiment includes the multilayer laminated region 34 having an area larger than that of the multilayer laminated region 34 of the semiconductor package of the first exemplary embodiment. In the second exemplary embodiment, the multilayer laminated region 34 is extended to the vicinity of four edges of the region depicted with a dotted line indicative of the mounting position of the semiconductor package 14a. In contrast, the second reinforcement resin layer 32 having a high adhesive strength is disposed on four corners of the mounting region of the semiconductor package 14a. Thus, the second reinforcement resin layer 32 having a high adhesive strength is provided on the four corners of the mounting region of the semiconductor package 14a without forming the multilayer laminated region 34 therein due to the fact that the corners of the mounting region of the semiconductor package 14a is easily subjected to large impact or stress.

### (Third Exemplary Embodiment Semiconductor Package)

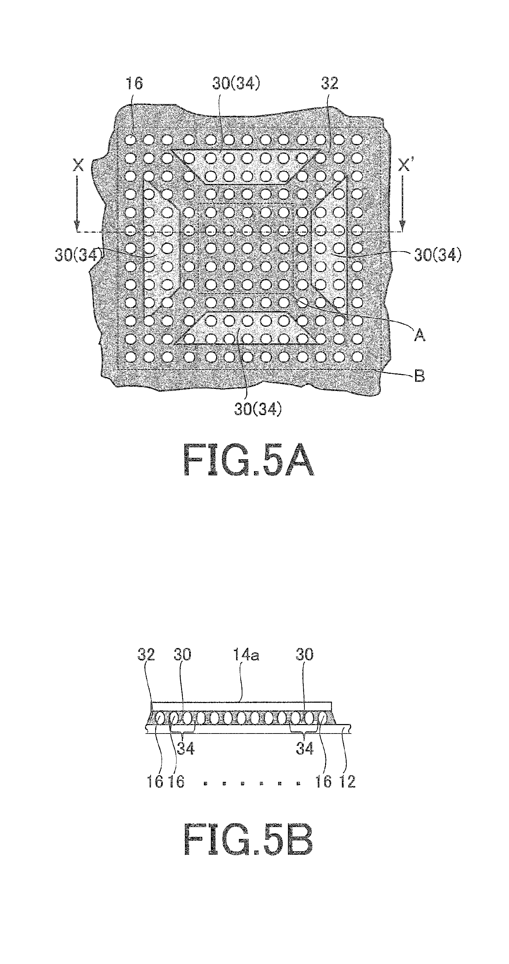

FIGS. 5A and 5B are diagrams illustrating a mount of the semiconductor package 14a of a third exemplary embodiment on the printed circuit board 12. The semiconductor package 14a of the third exemplary embodiment includes a rectangular mounting surface. Similarly to the first exemplary embodiment, the semiconductor package 14a includes a plurality of the solder bumps 16 disposed at predetermined intervals on the back surface thereof.

FIG. 5B is a cross-sectional view of the semiconductor package 14a mounted on the printed circuit board 12 illustrated in FIG. 5A, which is sectioned along a line X-X'.

The semiconductor package 14a of the third exemplary embodiment is soldered and electrically connected to a predetermined position on the printed circuit board 12. Simultaneously, the semiconductor package 14a is joined to the printed circuit board 12 using the first reinforcement resin layer 30 and the second reinforcement resin layer 32. The adhesive layer, disposed between the printed circuit board 12 and the semiconductor package 14a, partially includes a plurality of the multilayer laminated regions 34. Each multilayer laminated region 34 includes the first reinforcement resin layer 30 as a lower layer and the second reinforcement resin layer 32 as an upper layer. The second reinforcement resin layer 32 has an adhesive strength greater than that of the first reinforcement resin layer 30. The first reinforcement resin layer 30 is herein preferably an adhesive layer containing a thermoplastic rein, whereas the second reinforcement resin layer 32 is preferably an adhesive layer containing a thermosetting resin.

The semiconductor package 14a includes a semiconductor chip therein. A region enclosed by a dotted line A in FIG. 5A represents a region corresponding to a mounting region of the semiconductor chip on the adhesive layer. On the other hand, a region enclosed by a dotted line B in FIG. 5A represents a region indicative of the mounting position of the semiconductor package 14a on the adhesive layer.

As illustrated in FIG. 5A, four multilayer laminated regions 34 are disposed on the outside of the region corresponding to the mounting region of the semiconductor chip on the adhesive layer (the region enclosed by the dotted line A; hereinafter referred to as "a corresponding region") and away from the edge portion of the corresponding region. In other words, the multilayer laminated regions 34 are disposed on the outside of the edge portion of the aforementioned corresponding region on the adhesive layer, more specifically, on a region sandwiched between the edge portion of the corresponding region and the edge portion of the region indicative of the mounting position of the semiconductor package 14a (i.e., the region enclosed by the dotted line B). Further, four multilayer laminated regions 34 are disposed in four regions partitioned by two diagonals of the region indicative of the mounting position of the semiconductor package 14a and away from the diagonals.

The multilayer laminated regions 34 are thus disposed within the region sandwiched between the edge portion of the region enclosed by the dotted line B and the edge portion of the region enclosed by the dotted line A due to the fact that the sandwiched region is subjected to relatively small stress or impact. Further, the first reinforcement resin layer 30, having a low adhesive strength, has no negative impact on reinforcement of the joint between the semiconductor package 14a and the printed circuit board 12, even when the first reinforcement resin layer 30 is used for the aforementioned sandwiched region.

Thermal stress is easily produced on the edge portion of the aforementioned corresponding region for the semiconductor chip (i.e., the region enclosed by the dotted line A) due to heating of the semiconductor chip. On the other hand, the edge portion of the region indicative of the mounting position of the semiconductor package 14a (i.e., the region enclosed by the dotted line B) is easily subjected to stress or impact related to physical external force. Therefore, the edge portions are reliably reinforced by the second reinforcement resin layer 32 having a high adhesive strength.

Further, four multilayer laminated regions 34 are disposed on predetermined positions and away from the diagonals of the region indicative of the mounting position of the semiconductor package 14a due to the fact that regions in the vicinity of the diagonals are also easily subjected to stress or impact. Therefore, the regions in the vicinity of the diagonals are reliably reinforced by the second reinforcement resin layer 32.

### (Fourth Exemplary Embodiment Semiconductor Package)

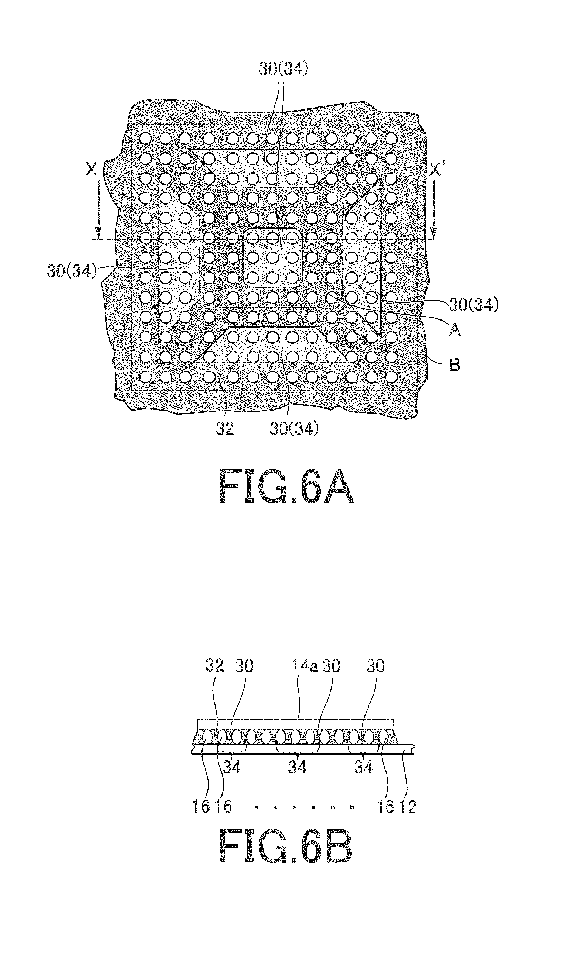

FIGS. 6A and 6B are diagrams illustrating a mount of the semiconductor package 14a of a fourth exemplary embodiment on the printed circuit board 12. The semiconductor package 14a of the fourth exemplary embodiment includes a rectangular mounting surface. Similarly to the first exemplary embodiment, the semiconductor package 14a also includes a plurality of the solder bumps 16 disposed at predetermined intervals on the back surface thereof.

FIG. 6B is a cross-sectional view of the semiconductor package 14a mounted on the printed circuit board 12 illustrated in FIG. 6A, which is sectioned along a line X-X'.

The semiconductor package 14a of the fourth exemplary embodiment is different from that of the third exemplary embodiment in that the multilayer laminated regions 34 are disposed on an inner portion of the region corresponding to the mounting region of the semiconductor chip on the adhesive layer (i.e., a region enclosed by a dotted line A; hereinafter referred to as "a corresponding region") and away from an edge portion of the corresponding region.

The semiconductor package 14a of the fourth exemplary embodiment is the same as that of the third exemplary embodiment in that four multilayer laminated regions 34 are disposed on the outside of the edge portion of the aforementioned corresponding region and away from the edge portion of the corresponding region, more specifically, on a region sandwiched between the edge portion of the corresponding region and a edge portion of a region indicative of the mounting position of the semiconductor package 14a on the adhesive layer (i.e., the region enclosed by a dotted line B). Therefore, explanation of the above structure will be hereinafter omitted.

The multilayer laminated regions 34 are thus disposed on the inner portion of the corresponding region (i.e., the region enclosed by the dotted line A) and away from the edge portion of the corresponding region due to the fact that the inner portion of the corresponding region is subjected to relatively small stress or impact. Therefore, the first reinforcement resin layer 30, having a low adhesive strength, have no negative impact on reinforcement of the joint between the semiconductor package 14a and the printed circuit board 12 even when the first reinforcement resin layer 30 is used for the inner portion of the corresponding region.

### (Semiconductor Package Mounting Method)

Next, explanation will be given for a method of fabricating the printed circuit board unit 10 that the semiconductor package 14a is mounted on the printed circuit board 12.

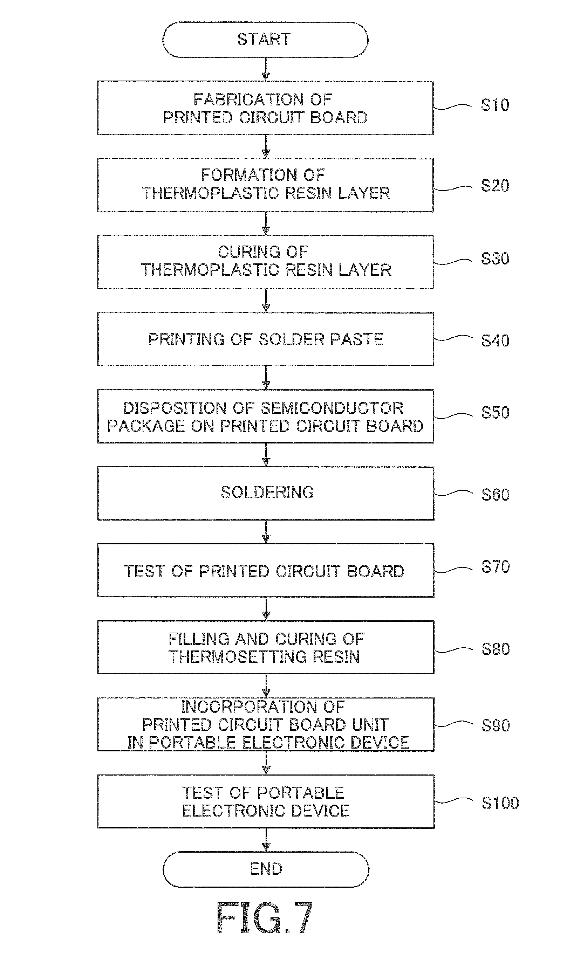

FIG. 7 is a flowchart illustrating a flow mainly focusing on mounting of the semiconductor package 14a on the printed circuit board 12 in the method of fabricating the printed circuit board unit 10.

First, the printed circuit board 12 is fabricated using a heretofore known method (Step S10).

For example, the printed circuit board 12 is fabricated by executing a finishing processing with respect to a substrate as the final step of fabricating the printed circuit board 12.

Subsequently, a single or plurality of the multilayer laminated regions 34 are determined in response to a prospective mounting position of the semiconductor package 14a. A thermoplastic resin is applied or printed to the determined position/positions of the multilayer laminated region/regions 34. Accordingly, a thermoplastic resin layer is formed (Step S20). For example, an acryl series resin, a polyester series resin or a vinyl chloride series resin is used as the thermoplastic resin.

Next, the formed thermoplastic resin layer is cured or half-cured (B-staged) (Step S30). Accordingly, the first reinforcement resin layer 30, containing a thermoplastic resin, is formed. The method of curing a resin depends on the types of the applied or printed thermoplastic resin. If the thermoplastic resin is a photosensitive resin, more specifically, an ultraviolet-curable resin, for instance, the thermoplastic resin is cured or half-cured when being exposed to irradiation of ultraviolet light. In this case, the mounting pad/pads of the printed circuit board 12 is not provided with the first reinforcement resin layer 30 for allowing the mounting pad/pads to be connected to the solder bumps 16 of the semiconductor package 14a. Therefore, the thermoplastic resin is partially exposed to the ultraviolet light using an exposure mask for preventing the thermoplastic resin disposed on the mounting pad/pads from being exposed to the irradiation of the ultraviolet light. Subsequently, the thermoplastic resin of a pre-cured state will be removed.

The thickness of the thermoplastic resin herein formed is less than the height of solder bumps described below to be formed between the semiconductor package 14a and the printed circuit board 12.

The first reinforcement resin layer 30 may be formed as follows. Instead of printing of the ultraviolet-curable resin, a liquid resin may be printed along a print pattern that does not overlap the mounting pad/pads, and may be subsequently cured or half-cured. Alternatively, a thermoplastic resin layer may be formed by attaching a thermoplastic resin sheet having a hole in alignment with the mounting pad/pads to the printed circuit board 12 by means of thermal compression. Accordingly, the first reinforcement resin layer 30, containing a thermoplastic resin, is formed.

Subsequently, a solder paste is printed on the mounting pad/pads of the printed circuit board 12 on which the first reinforcement resin layer 30 is formed (Step S40). The solder paste is formed using a cream solder printer and a metal mask.

Further, a semiconductor package 14a is disposed on the printed circuit board 12 using a solder repair apparatus (Step S50). Subsequently, the solder bumps 16 of the semiconductor package 14a are joined to the mounting pad/pads, including the solder paste thereon, of the printed circuit board 12 by melting of the solder (Step S60).

Subsequently, a continuity test and a function test for checking whether or not the semiconductor package 14a normally functions are executed for the printed circuit board 12 that the semiconductor package 14a is joined (Step S70).

When the semiconductor package 14a passes the tests, a thermosetting resin is filled and cured in the clearance between the semiconductor package 14a and the printed circuit board 12 (Step S80). When the semiconductor package 14a fails the tests, on the other hand, the semiconductor package 14a is removed from the printed circuit board 12 and replaced by another semiconductor package 14a. In this case, a thermosetting resin is not filled in the aforementioned clearance. It is thereby easy to remove the failed semiconductor package 14a from the printed circuit board 12 by heating the first reinforcement resin layer 30 containing a thermoplastic resin and melting the solder bumps 16.

For example, an epoxy resin or a phenol resin is herein used as the thermosetting resin. The thermosetting resin is herein cured by means of heating, which causes to make a polymerization reaction and to form a polymer network structure.

Further, the thickness of the first reinforcement resin layer 30 is less than the clearance between the semiconductor package 14a and the printed circuit board 12. A clearance is therefore produced between the surface of the semiconductor package 14a and the first reinforcement resin layer 30 before filling of the thermosetting resin. Further, a clearance is produced between the semiconductor package 14a and the printed circuit board 12 on a region that the first reinforcement resin layer 30 is not formed. The thermosetting resin is filled in the clearances, and the second reinforcement resin layer 32 is formed as illustrated in FIGS. 2A, 2B, 4A, 4B, 5A, 5B, 6A and 6B. Accordingly, a single or plurality of regions is formed, which include the second reinforcement resin layer 32 as an upper layer on the first reinforcement resin layer 30. The region/regions are the multilayer laminated region/regions 34.

In addition to the semiconductor package 14a, the semiconductor packages 14b to 14e are mounted on the printed circuit board 12. The printed circuit board unit 10 is accordingly fabricated.

The fabricated printed circuit board unit 10 is incorporated in the portable electronic device 20 (Step S90). A function test is then executed for the portable electronic device 20 (Step S100).

As described above, the first reinforcement resin layer 30 containing a thermoplastic resin is cured on the printed circuit board 12 and a solder paste is applied thereon in forming the multilayer laminated region/regions 34. It is possible to prevent the solder paste and the first reinforcement resin layer 30 of a pre-cured state from being mixed. In other words, soldering can be efficiently executed.

Further, the adhesion surface of the semiconductor package 14a is bonded to the printed circuit board 12 through the second reinforcement resin layer 32 containing a thermosetting resin to be filled and cured after soldering. Therefore, the joint between the semiconductor package 14a and the printed circuit board 12 is sufficiently reinforced by the second reinforcement resin layer 32 even when the adhesive strength of the first reinforcement resin layer 30 is reduced by reheating in the soldering process.

The first reinforcement resin layer 30 contains a thermoplastic resin. Therefore, the adhesive strength of the first reinforcement resin layer 30 with respect to the printed circuit board 12 is reduced by means of reheating. The semiconductor package 14a can be thereby easily removed from the printed circuit board 12, as illustrated in FIG. 3.

According to the present exemplary embodiment, the joint of the semiconductor package to the printed circuit board can be sufficiently reinforced when the semiconductor package is mounted on the printed circuit board while being allowed to be repaired.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiment(s) of the present inventions have been described in detail, it should be understood that the various changes, substitutions, and alternations could be made hereto without departing from the spirit and scope of the invention.

## Claims

1. A printed circuit board unit that an electronic component is mounted on a printed circuit board, comprising:
a printed circuit board; and
an electronic component electrically connected to a predetermined position on the printed circuit board by means of soldering, the electronic component joined to the printed circuit board using an adhesive layer,
wherein the adhesive layer between the printed circuit board and the electronic component partially includes a multilayer laminated region including a first reinforcement resin layer and a second reinforcement resin layer, the first reinforcement resin layer disposed on a side of the printed circuit board, the second reinforcement resin layer disposed on a side of the electronic component, the second reinforcement resin layer having an adhesive strength greater than an adhesive strength of the first reinforcement resin layer.

2. The printed circuit board unit according to claim 1, wherein the second reinforcement resin layer extends in a peripheral region of the multilayer laminated region to surround the first reinforcement resin layer of the multilayer laminated region.

3. The printed circuit board unit according to claim 1 or 2, wherein the first reinforcement resin layer contains a thermoplastic resin and the second reinforcement resin layer contains a thermosetting resin.

4. The printed circuit board unit according to any one of claims 1 to 3,
wherein the electronic component is a semiconductor package having a semiconductor chip embedded therein, and
the multilayer laminated region is disposed on the outside of a corresponding region indicative of a region corresponding to a mounting region of the semiconductor chip on the adhesive layer and away from an edge portion of the corresponding region on the adhesive layer.

5. The printed circuit board unit according to claim 4, wherein the region corresponding to the mounting region of the electronic component on the adhesive layer has a rectangular shape, and the multilayer laminated region is in a region partitioned by two diagonals of the rectangular shape and away from the diagonals.

6. A printed circuit board unit that an electronic component is mounted on a printed circuit board, comprising:
a printed circuit board; and
an electronic component electrically connected to a predetermined position on the printed circuit board by means of soldering, the electronic component joined to the printed circuit board by means of an adhesive material,
wherein the adhesive layer between the printed circuit board and the electronic component partially includes a plurality of multilayer laminated regions, each of the multilayer laminated regions including a first reinforcement resin layer and a second reinforcement resin layer, the first reinforcement resin layer disposed on a side of the printed circuit board, the second reinforcement resin layer disposed on a side of the electronic component, the second reinforcement resin layer having an adhesive strength greater than an adhesive strength of the first reinforcement resin layer,
the electronic component is a semiconductor package having a semiconductor chip embedded therein,
one of the multilayer laminated regions is disposed in an inner portion of a corresponding region indicative of a region corresponding to a mounting region of the semiconductor chip on the adhesive layer and away from an edge portion of the corresponding region on the adhesive layer, and
at least one of the multilayer laminated regions is disposed on an outside of the corresponding region and away from the edge portion of the corresponding region.

7. The printed circuit board unit according to claim 6, wherein the region corresponding to the mounting region of the electronic component on the adhesive layer has a rectangular shape, and each of the multilayer laminated regions is in a region partitioned by two diagonals of the rectangular shape and away from the diagonals.

8. An electronic device having a printed circuit board unit embedded therein,
wherein the printed circuit board unit comprises: a printed circuit board; and an electronic component electrically connected to a predetermined position on the printed circuit board by means of soldering, the electronic component joined to the printed circuit board using an adhesive layer, and
the adhesive layer between the printed circuit board and the electronic component partially includes a multilayer laminated region including a first reinforcement resin layer and a second reinforcement resin layer, the first reinforcement resin layer disposed on a side of the printed circuit board, the second reinforcement resin layer disposed on a side of the electronic component, the second reinforcement resin layer having an adhesive strength greater than an adhesive strength of the first reinforcement resin layer.

9. A method of fabricating a printed circuit board unit that an electronic component is mounted on a printed circuit board, comprising:
forming a first reinforcement resin layer on the printed circuit board, the first reinforcement resin layer containing a thermoplastic adhesive material, the first reinforcement resin layer being either cured or half-cured;
applying a solder paste on a mounting pad of the printed circuit board on which the first reinforcement resin layer is formed;
joining the mounting pad of the printed circuit board on which the solder paste is formed and a solder bump of the electronic component to be mounted on the printed circuit board; and
forming a second reinforcement resin layer by filling and curing a second adhesive material in a clearance between the electronic component and the printed circuit board and a clearance between the first reinforcement resin layer and the electronic component for reinforcing joint of the electronic component to the printed circuit board, the second adhesive material having an adhesive strength greater than an adhesive strength of the thermoplastic adhesive material.

10. The method of fabricating a printed circuit board unit according to claim 9, wherein the second reinforcement resin layer is formed to surround the first reinforcement resin layer.

11. The method of fabricating a printed circuit board unit according to claim 9 or 10, wherein the second reinforcement resin layer contains a thermosetting adhesive material.

12. The method of fabricating a printed circuit board unit according to any one of claims 9 to 11,
wherein the electronic component is a semiconductor package having a semiconductor chip embedded therein, and
the first reinforcement resin layer is formed on the outside of a corresponding region indicative of a region corresponding to a prospective mounting region of the semiconductor chip and away from the corresponding region on the print circuit board.

13. The method of fabricating a printed circuit board unit according to claim 12, wherein the first reinforcement resin layer is further formed on an inner portion of the corresponding region and away from the edge portion of the corresponding region on the print circuit board.

14. The method of fabricating a printed circuit board unit according to any one of claims 9 to 13,
wherein a prospective mounting region of the electronic component has a rectangular shape, and
the first reinforcement resin layer is further formed in a region partitioned by two diagonals of the rectangular shape and away from the diagonals.
